Europäisches Patentamt

European Patent Office

Office européen des brevets

(11) Veröffentlichungsnummer: **0 254 029 B1**

## (12) EUROPÄISCHE PATENTSCHRIFT

(45) Veröffentlichungstag der Patentschrift: **21.07.93**

(21) Anmeldenummer: **87108672.4**

(22) Anmeldetag: **16.06.87**

(51) Int. Cl.⁵: **G05B 13/02**

(54) **Verfahren zum Filtern eines verrauschten Signals.**

(30) Priorität: **20.06.86 DE 3620614**

(43) Veröffentlichungstag der Anmeldung:
**27.01.88 Patentblatt 88/04**

(45) Bekanntmachung des Hinweises auf die
Patenterteilung:
**21.07.93 Patentblatt 93/29**

(84) Benannte Vertragsstaaten:
**CH DE FR GB IT LI NL**

(56) Entgegenhaltungen:
**DE-A- 2 412 641
DE-A- 2 712 303
DE-A- 2 839 654
GB-A- 1 184 069
US-A- 3 860 759**

**PATENT ABSTRACTS OF JAPAN vol. 9, no. 277 (E-355) 2000 06 November 1985, & JP-A-60 120611 (FUJI DENKI SEIZO K.K.)**

**PATENT ABSTRACTS OF JAPAN vol. 9, no. 61 (E-303) 1784 19 März 1985, & JP-A-59 201509 (SHIMADA RIKA KOGYO K.K.)**

**PATENT ABSTRACTS OF JAPAN vol. 10, no. 91 (E-394) 2148 09 April 1986, & JP-A-60**

**233965 (YAESU MUSEN K.K.)**

(73) Patentinhaber: **MAN Gutehoffnungshütte Aktiengesellschaft
Bahnhofstrasse 66 Postfach 11 02 40
W-4200 Oberhausen 11(DE)**

(72) Erfinder: **Blotenberg, Wilfried
Irkenbusch 28
422 Dinslaken(DE)**

(74) Vertreter: **Glawe, Delfs, Moll & Partner Patentanwälte
Rothenbaumchaussee 58 Postfach 2570
W-2000 Hamburg 13 (DE)**

**Beschreibung**

Die Erfindung betrifft ein Verfahren zum Filtern je eines mit Rauschen oder Schwankungen behafteten Eingangssignals für einen Regler, insbesondere einen Pumpgrenzregler für Turboverdichter. Bei derartigen Reglern, die von mit "Rauschsignalen" überlagerten Meßgrößen angesteuert werden, ist eine Filterung der Meßgrößen wegen der Zeitverzögerung, die jedes Filter mit sich bringt, äußerst problematisch.

Pumpgrenzregelungen sind allgemein derart aufgebaut, daß aus dem Kompressorenddruck oder dem Druckverhältnis der minimal zulässige Durchsatz ermittelt wird und dieser mit dem gemessenen Kompressordurchsatz verglichen wird. Bei zu geringem Durchsatz würde das sogenannte Pumpen auftreten, bei dem stoßweise bzw. periodisch das Fördermedium von der Druckseite zur Saugseite zurückströmt. Die sogenannte Pumpgrenzlinie trennt im Kennfeld eines Kompressors den stabilen vom instabilen Bereich, in welchem ein Pumpen auftreten könnte. Die Pumpgrenzregelung sorgt dafür, daß bei Annäherung des aktuellen Arbeitspunktes an die Pumpgrenzlinie bzw. eine in einem Sicherheitsabstand parallel zu dieser verlaufende Abblaselinie ein Abblas- oder Umblasventil am Kompressorausgang geöffnet wird. Dabei ist die Größe, die sich am schnellsten ändern kann, der Kompressordurchsatz. Die Durchsatzmeßsignale sind aber stets mit einem Rauschsignal oder Schwankungen überlagert, gleichgültig, ob der Durchsatz mittels einer Blende, eines Staurohres, mit Hilfe des Druckverlustes am Kompressoreintritt oder auf eine sonstige Art erfaßt wird.

Dieses Rauchsignal hat seinen Ursprung darin, daß sich an den Durchflußmeßstellen stets Strömungswirbel bilden. Dies hat zur Folge, daß auch bei konstantem Durchsatz das Meßsignal ständigen Schwankungen unterworfen ist, welche nachteilig für die nachfolgenden Verarbeitungsschaltungen, z.B. Regler, Schreiber, Anzeiger, Datalogger, Analysengeräte,usw. sind.

Bei derartigen Verarbeitungsschaltungen stört das Rauschen deshalb erheblich, weil es die Ermittlung des exakten Durchsatzes erschwert, da diese Meßgeräte stets eine "Bandbreite" erfassen. Es ist deshalb allgemein üblich, ein solches Rauschsignal durch Zwischenschaltung von Dämpfungsgliedern oder Filtern herauszufiltern, so daß ein rauschfreies Nutzsignal erzeugt wird.

Der Einsatz derartiger Dämpfungsglieder ist aber in Verbindung mit Pumpgrenzregelungen sehr unvorteilhaft. Jedes Dämpfungsglied bewirkt nämlich eine Verzögerung des Meßsignals, d.h. eine tatsächliche Änderung des Durchflusses wird nur verzögert der nachgeschalteten Verarbeitungsschaltung weitergegeben.

Da Pumpgrenzregelungen aber Sicherheitsregelungen sind, müssen diese so schnell wie möglich reagieren, um einen guten Schutz des Kompressors vor dem Betrieb im instabilen Bereich, d.h. vor dem Pumpen, zu erreichen.

Ein Verfahren zur Signalverarbeitung gemäß dem Oberbegriff des Patentanspruchs 1 ist beispielsweise aus der US-A-4 139 328 bekannt. Bei diesem Verfahren ist dem Pumpgrenzregler ein nichtlinearer Verstärker zugeordnet, der die Regeldifferenz abhängig vom Vorzeichen nichtlinear verstärkt. Negative Regeldifferenzen werden nicht verstärkt, positive Regeldifferenzen (d.h. Differenzen, die eine Annäherung an die Pumpgrenzlinie anzeigen) werden um einen Faktor 5 verstärkt. Aufgrund des Rauschens schwankt die Regeldifferenz auch im stationären Zustand permanent, so daß die positiven Rauschanteile zusätzlich verstärkt und die Rauschamplitude somit noch vergrößert wird.

Aus der JP-A-60 120611 ist ein Rauschfilter mit veränderbarer Zeitkonstante bekannt. Durch Vergleich des gefilterten, d.h. geglätteten Signals mit dem Eingangssignal wird die Rauschamplitude ermittelt und eine Zeitkonstante eingestellt, wobei bei großer Rauschamplitude eine große Zeitkonstante, bei kleiner Rauschamplitude eine kleine Zeitkonstante gewählt wird. Auf diese Weise erhält man zwar ein optimal an das Rauschen angepaßtes Filter, die oben dargestellten Probleme hinsichtlich der Zeitverzögerung sind allerdings auch hier vorhanden.

Aus der DE 24 12 641 D3 ist ein Filterverfahren bekannt, bei dem ein verrauschtes Eingangssignal verzögert wird und das verzögerte Eingangssignal vom aktuellen Eingangssignal abgezogen wird. Die somit gebildete Differenz wird nichtlinear verstärkt, so daß große Signalamplituden stärker verstärkt werden als kleine Signalamplituden. Die so nichtlinear verstärkte Signaldifferenz wird dem verzögerten und geglätteten Eingangssignal überlagert. Auf diese Weise wird einerseits ein geglättetes Ausgangssignal erhalten und andererseits werden sprunghafte Signaländerungen sehr schnell übertragen. Abhängig von der Kennlinie des Verstärkers besteht jedoch die Möglichkeit, daß auch das Rauschen verstärkt wird, was zu einer Überlastung des Stellgliedes führen kann.

Ein Filterverfahren, bei dem ebenfalls sprunghafte Änderungen schneller an den Signalausgang abgegeben werden, ist aus der DE 27 12 303 A1 bekannt. Bei diesem Verfahren wird das verrauschte Eingangssignal in einem Integrierglied geglättet. Zusätzlich wird die Differenz zwischen dem Eingangssignal und dem geglätteten Ausgangssignal nichtlinear verstärkt, wobei kleine Differenzamplituden nicht verstärkt werden. Größere Signalamplituden werden relativ stark verstärkt und dem Eingangssignal des Integriergliedes zuaddiert. Auf diese Weise werden sprunghafte Signaländerungen zwar schneller weitergegeben, jedoch muß auch die Integrationszeit des Integriergliedes berücksichtigt werden. Zudem ergibt sich auch hier eine höhere Belastung des Stellgliedes.

Um den Bereich, in dem der nichtlineare Verstärker ein Signal nicht verstärkt an die Rauschamplitude des Eingangssignals anzupassen, ist gemäß der DE 27 12 303 A1 ein Adaptionsglied angesehen, das den Bereich entsprechend einstellt. Weiterentwicklungen für ein derartiges Adaptionsglied sind beispielsweise der DE 28 39 654 A1 entnehmbar.

Dementsprechend liegt der Erfindung die Aufgabe zugrunde, ein Verfahren der eingangs genannten Art zu schaffen, durch das ein Ausfiltern des Rauschens aus dem Eingangssignal ermöglicht wird, ohne daß die Übertragung einer Meßsignaländerung in nachteiliger Weise verzögert wird.

Die Lösung dieser Aufgabe erfolgt durch das in Patentanspruch 1 angegebene Verfahren; die Unteransprüche betreffen vorteilhafte Ausgestaltungen der Erfindung.

Erfindungsgemäß kann z.B. im stationären Zustand, d.h. in dem Zustand, wo sich die Meßgröße nur im Rahmen des Rauschpegels ändert, das verwendete Filter eine sehr große Filterzeitkonstante haben. Dadurch wird im stationären Zustand das Rauschen aus dem Meßsignal herausgefiltert. Bewegt sich das System und somit die Meßgröße in den instationären Zustand, d. h. über den normalen Rauschpegel hinaus, so wird die Filterzeitkonstante des Filters so weit reduziert, daß die nachteilige Verzögerungswirkung des Filters nahezu ausgeschlossen wird.

Eine bevorzugte Möglichkeit, dies zu erreichen, ist, daß das Eingangssignal für den Regler vor der Zuführung zum Regler gefiltert wird, daß das gefilterte Signal mit dem ungefilterten Signal verglichen wird, und daß die Zeitkonstante des Filters in Abhängigkeit von der Größe und dem Vorzeichen der Differenz zwischen gefiltertem und ungefiltertem Signal eingestellt wird.

Dabei kann die Zeitkonstante beim einseitigen Überschreiten einer Schaltschwelle in einer Grenzwertstufe auf einen fest vorgewählten Wert reduziert werden und unmittelbar nach dem Wiederunterschreiten wieder auf die ursprüngliche Zeitkonstante eingestellt werden.

Eine alternative Durchführungsform des erfindungsgemäßen Verfahrens besteht darin, daß die Zeitkonstante nur in eine der Richtungen der Signaländerung, insbesondere von der Pumpgrenze weg, wirksam ist, und in der anderen Richtung keine Verzögerung wirksam ist.

Dabei kann das Eingangssignal für den Regler einem Filter zugeführt werden, dessen Ausgangssignal den minimalen bzw. maximalen Augenblickswert des Eingangssignals repräsentiert, wobei eine gemittelte Rauschamplitude im Eingangssignal ermittelt wird und zu dem Ausgangssignal des Filters hinzuaddiert bzw. davon abgezogen wird.

Die Ermittlung der mittleren Rauschamplitude kann auf unterschiedliche Weise durchgeführt werden, z.B. durch eine Rechenschaltung oder durch ein Filterwerk, das das Eingangssignal filtert, das gefilterte mit dem ungefilterten Signal vergleicht und aus der Differenz die mittlere Rauschamplitude ermittelt. Die mittlere Rauschamplitude kann auch durch zwei asymmetrische Filter ermittelt werden, die in unterschiedlichen Richtungen unterschiedliche Zeitkonstanten haben. Dies wird vorzugsweise dadurch erreicht, daß Filter steigende Signale verzögert, sinkende unverzögert durchläßt, so daß sein Ausgang stets in der Nähe des minimalen Spitzenwertes liegt, während der andere Filter steigende Signale unverzögert und sinkende Signale verzögert passieren läßt, so daß sein Ausgang stets in der Nähe des maximalen Spitzenwertes liegt, und daß aus der Differenz dieser beiden Werte die doppelte mittlere Rauschamplitude ermittelt wird.Dabei kann die Zeitkonstante der asymmetrischen Filter auch variabel gestaltet sein.

Es gibt verschiedene Möglichkeiten, wann die mittlere Rauschamplitude ermittelt wird. Sie kann z.B. einmal bei Inbetriebnahme des Reglers ermittelt und dann fest eingestellt werden, oder periodisch wiederkehrend ermittelt werden. Ferner kann sie auch kontinuierlich ermittelt werden oder jedesmal bei Änderung eines Prozeßparameters.

Für beide Alternativen des erfindungsgemäßen Verfahrens ist es von Vorteil, wenn die Filterzeitkonstante zusätzlich vom Ausgangssignal oder der Regeldifferenz des Pumpgrenzreglers beeinflußt wird. Diese Regeldifferenz wird vorzugsweise so ermittelt, daß die Filterzeitkonstante unwirksam ist.

Durch das erfindungsgemäße Filterverfahren wird erreicht, daß bei Änderung der Meßgröße, d.h. beim Übergang in den instationären Zustand, die Zeitkonstante so klein gemacht wird, daß das Regelsystem ohne Zeitverluste nachregeln kann, und zwar bevorzugt bei Änderung in eine gefährdete Richtung, während andererseits im stationären Zustand eine gute Filterung des Meßsignales, und damit ein rauschfreies Meßsignal erzielt werden kann.

Weitere Vorteile und Merkmale ergeben sich aus den Unteransprüchen.

Im folgenden wird die Erfindung anhand der Figuren unter Bezugnahme auf Ausführungsbeispiele genauer beschrieben. Es zeigen:

Fig. 1 eine schematische Schaltung zur Durchführung eines ersten erfindungsgemäßen Filterverfahrens;

Fig. 2 eine Schaltungsanordnung zur Durchführung eines modifizierten Filterverfahrens;

Fig. 3 eine Schaltungsanordnung zur Durchführung eines Filterverfahrens ähnlich dem von Fig. 2;

Fig. 4 eine Schaltungsanordnung zur Durchführung eines alternativen Filterverfahrens;

Fig. 5 eine Schaltung zur Ermittlung der mittleren Rauschamplitude eines Eingangssignals; und

Fig. 6 eine weitere Schaltung zur Durchführung des erfindungsgemäßen Verfahrens.

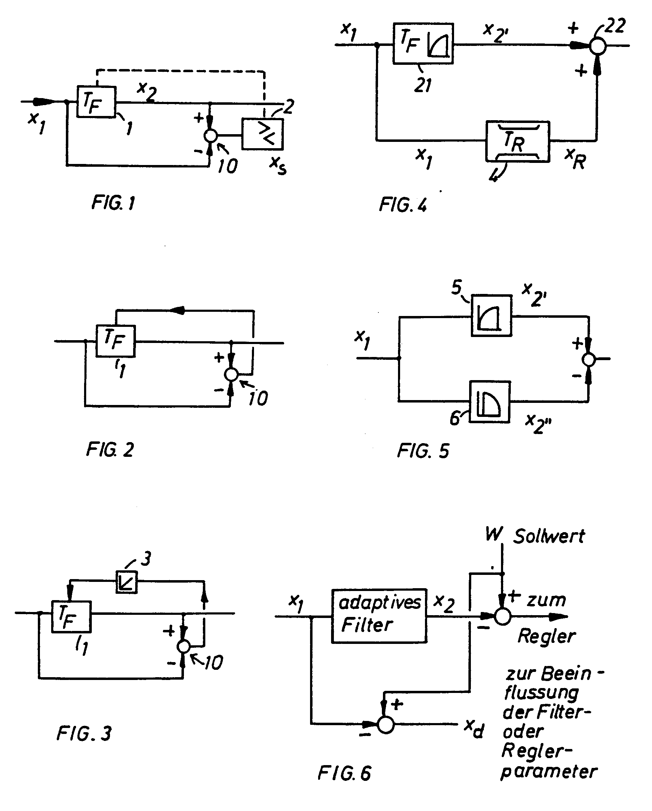

In Fig. 1 wird ein Eingangssignal $X_1$, welches ein rauschbehaftetes Meßsignal darstellt, einer Filterschaltung 1 mit der variablen Filterzeitkonstanten $T_F$ zugeführt. Das aktuelle Meßsignal $X_1$ setzt sich zusammen aus der exakten Meßgröße $X_M$ und einem Rauschsignal $X_R$, welches der exakten Meßgröße überlagert ist.

Das aktuelle Meßsignal wird durch die Filterschaltung 1 mit der entsprechenden Filterzeitkonstante gefiltert und dadurch geglättet. Dieses geglättete Signal $X_2$ wird dann zu einem (nicht gezeigten) Regler weitergeleitet, der das geglättete Signal als eines seiner Steuersignale verwendet.

Andererseits wird das aktuelle Meßsignal $X_1$ vor der Filterung von der Eingangsleitung abgezweigt und einem Komparator 10 zugeführt, der dieses aktuelle Meßsignal mit dem gefilterten bzw. geglätteten Signal $X_2$ vergleicht.

Solange sich das System im stationären Betriebszustand befindet, wird der Unterschied zwischen den Signalen $X_1$ und $X_2$ maximal so groß sein, wie die maximale Amplitude des Rauschens. Daher kann ein stationärer Betriebszustand immer dann angenommen werden, wenn die Differenz zwischen den Signalen $X_2$ und $X_1$, also das Ausgangssignal aus dem Komparator 10, kleiner als die Rauschamplitude $\hat{X}_R$ ist.

Das Ausgangssignal des Komparators 10 wird einer Grenzwertstufe 2 zugeführt. Diese Grenzwertstufe 2 ist so ausgestaltet, daß sie zumindest beim einseitigen Überschreiten der Schaltschwelle $X_F$ der Grenzwertstufe 2 die Filterzeitkonstante $T_F$ der Filterschaltung 1 auf einen fest vorgewählten Wert reduziert. Dies kann gegebenenfalls auch der Wert Null sein, so daß die Filterschaltung 1 ohne nennenswerte Verzögerung auf Schwankungen im Eingangssignal reagieren kann und den Regler ohne Zeitverlust ansteuern kann.

Dadurch ist gewährleistet, daß die Änderung des Eingangssignales im - in diesem Falle vorliegenden - instationären Betriebszustand ohne größere Verzögerung übertragen wird. Beim Zurückkehren des Systems in den stationären Betriebszustand, d.h. beim Unterschreiten der Schaltschwelle $X_S$ der Grenzwertstufe 2 wird die Zeitkonstante $T_F$ der Filterschaltung 1 unmittelbar wieder auf den ursprünglichen Wert eingestellt.

Fig. 2 zeigt eine alternative Schaltung, bei welcher der Komparator nicht mit einer Grenzwertstufe 2 verbunden ist, sondern direkt mit der Filterschaltung 1. Dadurch wird die Filterzeitkonstante $T_F$ direkt vom Ausgangswert des Komparators 10, d.h. der Abweichung des gefilterten Signals vom echten Meßsignal, gesteuert. Das heißt, je größer die Abweichung des aktuellen Signales $X_1$ vom unmittelbar vorhergehenden geglätteten Signal $X_2$ wird, desto kleiner wird die Zeitkonstante gemacht, und desto schneller kann die Filterschaltung 1 reagieren.

In Fig. 3 wird eine weitere Alternative gezeigt. Hier wird das Ausgangssignal des Komparators 10 nicht der Filterschaltung 1 direkt zugeführt, sondern über eine Funktionseinheit 3, deren Ausgangssignal die Zeitkonstante $T_F$ verändert und nicht-linear vom Ausgangswert des Komparators 10 abhängt. Dadurch kann z.B. erreicht werden, daß die Reduktion der Filterzeitkonstanten nur in einer Richtung (z.B. zu kleineren Meßwerten $X_M$ wirksam wird. Die Schaltungen gemäß Fig. 1 und 3 können natürlich auch kombiniert werden, so daß eine Zeitkonstantenanpassung gemäß Fig.1 nur im instationären Zustand durchgeführt wird, aber gemäß der Schaltung von Fig. 3 für unterschiedliche Signaländerungsrichtungen mit unterschiedlichen Parametern für die Abhängigkeit von der Differenz zwischen gefiltertem und ungefiltertem Signal aus dem Komparator 10.

Eine derartige Schaltung ist in den Figuren nicht dargestellt, aber für den Fachmann ohne weiteres vorstellbar.

Auch wenn die Wahl der Zeitkonstanten und der Abhängigkeit der Zeitkonstanten von den Signaländerungen frei gewählt werden kann, so ist es doch selbstverständlich, daß die Filterschaltung zur Durchführung des erfindungsgemäßen Verfahrens vorzugsweise in Richtung auf gefährdete Signalbereiche, d.h. z.B. bei einer Pumpgrenzregelung in Richtung auf die Pumpgrenze hin, schneller bzw. empfindlicher ausgelegt wird. In die ungefährdete Signaländerungsrichtung kann die Schaltung zur Durchführung des Verfahrens relativ träge bzw. unempfindlich gestaltet werden.

Fig. 4 zeigt eine alternative Schaltung zum Durchführen eines Filterverfahrens.

Die Schaltung von Fig. 4 zeigt eine Filterschaltung 21, deren Filterzeitkonstante $T_F$ so gewählt ist, daß sie nur in eine Richtung wirksam ist, z.B. nur in Richtung sinkender Meßsignale $X_1$ bzw. $X_M$. Dies bedeutet, daß das Ausgangssignal $X_2$ des Filters 21 sich stets oder zumindest mit hoher Geschwindigkeit auf die Nähe des kleinsten Augenblickswertes des Eingangssignales $X_1$ einstellt.

In die andere Richtung der Signaländerungen kann die Zeitkonstante des Filters 21 relativ groß gewählt werden, so daß das Ausgangssignal $X_2'$ in

dieser Richtung relativ langsam abklingt. Hierdurch wird erreicht, daß das Ausgangssignals des Filters 21 zur empfindlichen, d.h. bevorzugterweise zur gefährdeten Seite hin, stets unverzögert folgt, während es in der entgegengesetzten, d.h. ungefährdeteren Signaländerungsrichtung verzögert bzw. träge folgt.

Da sich das Ausgangssignal $X_2'$ des Filters 21 aber immer auf einen Extremwert des Eingangssignals $X_1$ einstellt, liegt dieser aktuelle Wert um die mittlere Rauschamplitude des Eingangssignals $X_1$ verschoben. Um ein korrektes gefiltertes Meßsignal zu erhalten, ist es deshalb nötig, zu dem Ausgangssignal $X_2'$ das mittlere Rauschsignal $\hat{X}_R$ hinzuzuaddieren bzw. dieses davon abzuziehen. Hierzu dient eine weitere Meßschaltung 4, die aus dem Eingangssignal $X_1$ die mittlere Rauschamplitude ermittelt. Diese Schaltung 4 kann z.B. eine Filterschaltung gemäß Fig. 1 bis 3 sein, in welcher der Komparator 10 die Größe $X_2$ - $X_1$ ermittelt und diese als Rauschamplitude an den Addierer 22 liefert. Das Ausgangssignals des Addierers 22 dient dann als Steuersignal für den Regler (nicht gezeigt).

Eine weitere Alternative für die Meßschaltung 4 ist in Fig. 5 gezeigt.

Die Schaltung zur Ermittlung der mittleren Rauschamplitude von Fig. 5 zeigt zwei asymmetrische Filter 5,6. Der Filter 5 bzw. Filter 6 sind Filter, die in einer Richtung eine große Zeitkonstante, in der anderen jedoch eine kleine Zeitkonstante haben. Filter 5 z.B. läßt steigende Signale verzögert, sinkende jedoch unverzögert hindurch. Dies bedeutet, daß das Ausgangssignal des Filters 5, ähnlich wie der Ausgang des Filters 21 von Fig. 4, immer auf den minimalen Spitzenwert $X_2'$ des Eingangssignals $X_1$ liegt.

Der Filter 6 hingegen ist entgegengesetzt asymmetrisch, d.h. läßt steigende Signale unverzögert und fallende Signale mit Verzögerung passieren. Dies bedeutet, daß der Ausgang des Filters 6 stets in der Nähe des maximalen Spitzenwertes $X_2''$ des Eingangssignales $X_1$ liegt. Durch Differenzbildung zwischen den Extremwerten $X_2'$ und $X_2''$ läßt sich die doppelte mittlere Rauschamplitude ermitteln. Diese kann dann nach Halbierung im Addierwerk 22 gemäß Fig. 4 zum minimalen Spitzenwert addiert werden, um so das aktuelle gefilterte Signal bilden.

Eine weitere, in den Figuren nicht gezeigte Möglichkeit zur Ermittlung der mittleren Rauschamplitude wäre die Verwendung einer Rechnerschaltung, die innerhalb eines fest vorgegebenen Zeitraumes die maximalen bzw. minimalen Spitzenwerte des ungefilterten Eingangssignales mißt und speichert. Aus dem höchsten Maximalwert und dem kleinsten Minimalwert innerhalb dieses Zeitraumes wird die Differenz gebildet und diese halbiert. Dies ergibt die mittlere Rauschamplitude, die dem Addierer 22 zugeführt wird.

In gleicher Weise können natürlich auch die im Meßzeitraum erfaßten maximalen bzw. minimalen Spitzenwerte jeweils gemittelt werden und aus diesem Mittelwert die Differenz gebildet werden, um die doppelte Rauschamplitude zu erhalten.

Es gibt grundsätzlich mehrere Möglichkeiten, wann die mittlere Rauschamplitude ermittelt wird.

Eine der Möglichkeiten wäre, daß diese Größe bei Inbetriebnahme des Reglersystems zu Beginn einmal ermittelt wird und dann fest auf den ermittelten Wert eingestellt wird.

Eine weitere Möglichkeit, speziell z.B. für die Schaltung gemäß Fig. 5 wäre eine kontinuierliche Ermittlung der mittleren Rauschamplitude.

Außerdem kann diese Korrekturgröße mit irgendeinem der oben erwähnten Verfahren periodisch wiederkehrend ermittelt werden.

Eine weitere Möglichkeit besteht darin, daß eine Neuermittlung der mittleren Rauschamplitude jedesmal dann durchgeführt wird, wenn sich einer der Prozeßparameter ändert, z.B. bei Änderung von Durchsatz, Druck, Regeldifferenz des Pumpreglers, Drehzahl, Leitschaufelstellung, Leistung, Reglerausgang irgendeines beteiligten Reglers, usw.

Wenn während der Ermittlung der mittleren Rauschamplitude sich einer der Prozeßparameter ändert, kann die Ermittlung der Rauschamplitude gestoppt werden und sofort darauf wieder neu gestartet werden.

Fig. 6 stellt eine weitere Ausgestaltung der zuvor erwähnten Anordnungen dar. In der technischen Beschreibung wird mehrfach erwähnt, daß die Filterzeitkonstante abhängig von der Regeldifferenz variiert wird. Die Regeldifferenz wird jedoch üblicherweise als Differenz zwischen Sollwert und Istwert gebildet. Da jedoch das Filter in den Istwertzweig eingefügt ist, wird auch die Regeldifferenz durch das Filter beeinflußt.

Fig. 6 zeigt eine andere Variante. Hier werden zwei Regeldifferenzen gebildet. Für die Regeldifferenz, die dem Regler zugeführt wird, wird als Differenz zwischen Sollwert und gefiltertem Istwert gebildet. Die Regeldifferenz zur Beeinfussung der Filterparameter wird jedoch als Differenz zwischen Sollwert und ungefiltertem Istwert gebildet.

Das in Fig. 6 dargestellte adaptive Filter kann irgendeines der sonstigen Darstellungen sein.

**Patentansprüche**

1.  Verfahren zum Verarbeiten je eines mit Rauschen oder Schwankungen behafteten Eingangssignals ($X_1$) für einen in einem Regelsystem vorgesehenen Regler, wobei im Kennfeld des Regelsystems eine Grenzlinie definiert ist, dadurch **gekennzeichnet,** daß vor der Zuführung zum Regler das Eingangsignal durch ein Filter (1) mit einer veränderbaren Zeitkonstante gefiltert wird und daß der Signalpegel des Eingangssignals überwacht und bei einer Veränderung des Signalpegels, die einer Annäherung an die Grenzlinie entspricht, eine kleinere Zeitkonstante zum Filtern des Eingangssignals verwendet wird als bei einer Signalpegelveränderung, die einer Entfernung von der Grenzlinie entspricht.

2. Verfahren nach Anspruch 1, dadurch **gekennzeichnet,** daß das Eingangssignal ($X_1$) für den Regler vor der Zuführung zum Regler gefiltert wird, daß das gefilterte Signal ($X_2$) mit dem ungefilterten Signal ($X_1$) verglichen wird und daß die Zeitkonstante des Filters (1) in Abhängigkeit von der Größe und dem Vorzeichen der Differenz zwischen gefiltertem und ungefiltertem Signal eingestellt wird.

3. Verfahren nach Anspruch 2, dadurch **gekennzeichnet,** daß die Zeitkonstante ($T_F$) beim einseitigen Überschreiten einer Schaltschwelle ($X_S$) in einer Grenzwertstufe (2) auf einen festvorgewählten Wert reduziert wird, gegebenenfalls auf Null.

4. Verfahren nach Anspruch 3, dadurch **gekennzeichnet,** daß die Zeitkonstante ($T_F$) unmittelbar oder um eine Hystereseschwelle versetzt nach dem Unterschreiten der Schaltschwelle ($X_S$) wieder auf die ursprüngliche Zeitkonstante eingestellt wird.

5. Verfahren nach Anspruch 2, dadurch **gekennzeichnet,** daß die Zeitkonstante ($T_F$) abhängig von der Größe der Differenz zwischen gefiltertem und ungefiltertem Signal so eingestellt wird, daß bei größerer Differenz die Zeitkonstante kürzer ist.

6. Verfahren nach Anspruch 5, dadurch **gekennzeichnet,** daß die Einstellung der Zeitkonstante ($T_F$) nichtlinear von der Differenz zwischen gefiltertem und ungefiltertem Signal abhängt.

7. Verfahren nach Anspruch 2, dadurch **gekennzeichnet,** daß die unterschiedlichen Zeitkonstanten nur im instationären Zustand wirksam sind.

8. Verfahren nach einem der Ansprüche 1 bis 7, dadurch **gekennzeichnet,** daß abhängig vom Vorzeichen der Signaländerung die Zeitkonstante in unterschiedlicher Abhängigkeit von der Differenz zwischen gefiltertem und ungefiltertem Signal eingestellt wird.

9. Verfahren nach einem der Ansprüche 1 bis 7, dadurch **gekennzeichnet,** daß abhängig vom Vorzeichen der Signalpegeländerung die Zeitkonstante in der gleichen Abhängigkeit von der Differenz zwischen gefiltertem und ungefiltertem Signal, aber mit unterschiedlichen Parametern eingestellt wird.

10. Verfahren nach Anspruch 1 bis 9, dadurch **gekennzeichnet,** daß die veränderbare Zeitkonstante nur bei einer Signapegeländerung, die eine Annäherung an die Grenzlinie anzeigt, wirksam ist, und bei der anderen Signalpegeländerung der Filter mit fester Zeitkonstante wirkt.

11. Verfahren nach Anspruch 1, dadurch **gekennzeichnet,** daß die veränderbare Zeitkonstante nur bei einer Signalpegeländerung, die ein Entfernen von der Grenzlinie anzeigt, wirksam ist, und bei der anderen Signalpegeländerung keine Verzögerung wirksam ist.

12. Verfahren nach Anspruch 11, dadurch **gekennzeichnet,** daß bei beiden Signalpegeländerung eine endliche einstellbare Zeitkonstante wirksam ist.

13. Verfahren nach Anspruch 11, dadurch **gekennzeichnet,** daß das Eingangssignal für den Regler vor der Zuführung zum Regler gefiltert wird, wobei das gefilterte Signal den aktuellen maximalen bzw. minimalen Spitzenwert des Eingangssignals repräsentiert, daß die mittlere Rauschamplitude im Eingangssignal ermittelt wird, und daß die mittlere Rauschamplitude zum gefilterten Signal hinzuaddiert bzw. davon abgezogen wird.

14. Verfahren nach Anspruch 13, dadurch **gekennzeichnet,** daß das Eingangssignal gefiltert, das gefilterte mit dem ungefilterten Signal verglichen und aus ihrer Differenz die mittlere Rauschamplitude ermittelt wird.

15. Verfahren nach Anspruch 14, dadurch **gekennzeichnet,** daß das Filter zum Ermitteln des Augenblickwertes und das Filter zum Ermitteln der mittleren Rauschamplitude unterschiedliche Zeitkonstanten haben.

16. Verfahren nach Anspruch 13, dadurch **gekennzeichnet,** daß die mittlere Rauschamplitude ermittelt wird durch eine Rechenschaltung, die die maximalen und minimalen Spitzenwerte des Signals innerhalb einer fest vorgegebenen Zeitperiode speichert und aus dem höchsten Maximalwert und dem kleinsten Minimalwert innerhalb dieser Zeitperiode die Differenz bildet und durch zwei dividiert.

17. Verfahren nach Anspruch 16, dadurch **gekennzeichnet,** daß die Länge der Zeitperiode variabel gestaltet ist.

18. Verfahren nach Anspruch 13, dadurch **gekennzeichnet,** daß die mittlere Rauschamplitude durch zwei asymmetrische Filter (5,6) ermittelt wird, die bei einer Signaländerng in einer Richtung eine wirksame Zeitkonstante, in der anderen Richtung keine Zeitkonstante haben.

19. Verfahren nach Anspruch 17, dadurch **gekennzeichnet,** daß das Filter (5) steigende Signale verzögert, sinkende unverzögert durchläßt, so daß sein Ausgang stets in der Nähe des minimalen Spitzenwertes liegt, während das Filter (6) steigende Signale unverzögert und sinkende Signale verzögert passieren läßt, so daß sein Ausgang stets in der Nähe des maximalen Spitzenwertes liegt, und daß aus der Differenz dieser beiden Werte die doppelte mittlere Rauschamplitude ermittelt wird.

20. Verfahren nach Anspruch 18 oder 19, dadurch **gekennzeichnet,** daß die Zeitkonstante der asymmetrischen Filter (5,6) variabel gestaltet ist.

21. Verfahren nach Anspruch 13, dadurch **gekennzeichnet,** daß die mittlere Rauschamplitude bei Inbetriebnahme des Reglers einmalig ermittelt und dann auf den ermittelten Wert eingestellt wird.

22. Verfahren nach einem der Ansprüche 13 bis 20, dadurch **gekennzeichnet,** daß die mittlere Rauschamplitude periodisch wiederkehrend ermittelt wird und dann auf den ermittelten Wert eingestellt wird.

23. Verfahren nach einem der Ansprüche 13 bis 20, dadurch **gekennzeichnet,** daß die mittlere Rauschamplitude kontinuierlich ermittelt wird.

24. Verfahren nach einem der Ansprüche 13 bis 20, dadurch **gekennzeichnet,** daß die mittlere Rauschamplitude immer bei Änderung eines Prozeßparameters des Regelsystems, z.B. Durchfluß, Druck, Regeldifferenz des Pumpreglers, Drehzahl, Leitschaufelstellung oder Leistung eines Turbokompressors oder des Reglerausgangs irgendeines beteiligten Reglers usw. ermittelt und dann auf den ermittelten Wert eingestellt wird.

25. Verfahren nach einem der Ansprüche 13 bis 20, 22 oder 24, dadurch **gekennzeichnet,** daß beim Auftreten einer Änderung eines Prozeßparameters des Regelsystems während der Ermittlung der mittleren Rauschamplitude die Ermittlung sofort abgebrochen und neugestartet wird.

26. Verfahren nach einem der Ansprüche 13 bis 23, dadurch **gekennzeichnet,** daß auf die ermittelte mittlere Rauschamplitude ein Sicherheitszuschlag aufaddiert wird.

27. Verfahren nach einem der Ansprüche 1 bis 26, dadurch **gekennzeichnet,** daß der Regler ein Pumpgrenzregler für Turbokompressoren ist und daß die Zeitkonstante zusätzlich vom Ausgangssignal des Pumpgrenzreglers beeinflußt wird.

28. Verfahren nach einem der Ansprüche 1 bis 26, dadurch **gekennzeichnet,** daß der Regler ein Pumpgrenzregler für Turbokompressoren ist und daß die Filterkonstante zusätzlich von der Regeldifferenz des Pumpgrenzreglers beeinflußt wird.

29. Verfahren nach einem der Ansprüche 1 bis 28, dadurch **gekennzeichnet,** daß die Änderung bzw. Einstellung der Zeitkonstanten nicht unmittelbar beim Eintreten der entsprechenden Bedingung eintritt, sondern zeitlich verzögert wird.

30. Verfahren nach Anspruch 29, dadurch **gekennzeichnet,** daß die Änderung der Zeitkonstanten nicht unmittelbar beim Eintreten der entsprechenden Bedingung eintritt, sondern erst nachdem eine oder mehrere der Einflußgrößen eine Sicherheitsschwelle überschritten haben.

31. Verfahren nach Anspruch 28, dadurch **gekennzeichnet,** daß die Regeldifferenz derart gebildet wird, daß die Zeitkonstante unwirksam ist.

32. Verfahren nach Anspruch 29 oder 30, dadurch **gekennzeichnet,** daß die zeitliche Verzögerung bzw. die Sicherheitsschwelle abhängig ist vom Betrag der eingangsseitig festgestellten Abweichung.

33. Verfahren nach Anspruch 32, dadurch **gekennzeichnet,** daß die zeitliche Verzögerung bzw. die Sicherheitsschwelle abhängig vom Gradienten der Differenz zwischen Filtereingang- und -ausgang verstellt wird.

## Claims

1. A method of processing every input signal ($X_1$) which is affected by noise or fluctuations for a controller provided in a control system, wherein a limit line is defined on the characteristic diagram of the control system, characterised in that before being fed to the controller the input signal is filtered by a filter (1) with a variable time constant, and that the signal level of the input signal is monitored and on a variation in the signal level which corresponds to an approach to the limit line a time constant is used for filtering the input signal which is less than that used for a signal level variation which corresponds to a departure from the limit line.

2. A method according to claim 1, characterised in that the input signal ($X_1$) for the controller is filtered before being fed to the controller, that the filtered signal ($X_2$) is compared with the unfiltered signal ($X_1$) and that the time constant of the filter (1) is adjusted depending on the magnitude and the algebraic sign of the difference between the filtered and the unfiltered signal.

3. A method according to claim 2, characterised in that the time constant ($T_F$) is reduced to a predetermined fixed value, optionally to zero, when a switching threshold ($X_S$) in a limiting value stage (2) is exceeded on one side.

4. A method according to claim 3, characterised in that after a failure to reach the switching limit ($X_S$) the time constant ($T_F$) is readjusted either directly or displaced by a hysteresis threshold to the original time constant.

5. A method according to claim 2, characterised in that the time constant ($T_F$) is adjusted depending on the magnitude of the difference between the filtered and unfiltered signal so that when the difference is greater the time constant is less.

6. A method according to claim 5, characterised in that the adjustment of the time constant ($T_F$) depends non-linearly on the difference between the filtered and unfiltered signal.

7. A method according to claim 2, characterised in that the different time constants are only effective in the unsteady state.

8. A method according to any one of claims 1 to 7, characterised in that depending on the algebraic sign of the signal variation the time constant is adjusted with a differing dependence on the difference between the filtered and unfiltered signal.

9. A method according to any one of claims 1 to 7, characterised in that depending on the algebraic sign of the signal level variation the time constant is adjusted with a constant dependence on the difference between the filtered and unfiltered signal, but with different parameters.

10. A method according to claims 1 to 9, characterised in that the variable time constant is only effective for a signal level alteration which exhibits an approach to the limit line, and the filter acts with a fixed time constant for the other signal level alteration.

11. A method according to claim 1, characterised in that the variable time constant is only effective for a signal level alteration which exhibits a departure from the limit line, and no delay is effective for the other signal level alteration.

12. A method according to claim 11, characterised in that a finite adjustable time constant is effective for both signal level alterations.

13. A method according to claim 11, characterised in that the input signal for the controller is filtered before being fed to the controller, wherein the filtered signal represents the instantaneous maximum or minimum peak value of the input signal, that the mean noise amplitude in the input signal is determined, and that the mean noise amplitude is added to or subtracted from the filtered signal.

14. A method according to claim 13, characterised in that the input signal is filtered, the filtered signal is compared with the unfiltered signal, and the noise amplitude is determined from the difference between them.

15. A method according to claim 14, characterised in that the filter for determining the instantaneous value and the filter for determining the mean noise amplitude have different time constants.

16. A method according to claim 13, characterised in that the mean noise amplitude is determined by means of a computational circuit which stores the maximum and minimum peak values of the signal over a predetermined fixed time interval and which forms the difference between the highest maximum value and the lowest minimum value over this time interval and divides it by two.

17. A method according to claim 16, characterised in that the length of the time interval is made variable.

18. A method according to claim 13, characterised in that the mean noise amplitude is determined by two asymmetric filters (5, 6) which have an effective time constant when there is a signal alteration in one direction and which have no time constant in the other direction.

19. A method according to claim 17, characterised in that the filter (5) delays increasing signals and transmits decreasing signals undelayed, so that its output is always close to the minimum peak value, whilst the filter (6) allows increasing signals to pass undelayed and allows decreasing signals to pass with a delay, so that its output is always close to the maximum peak value, and that twice the mean value of the noise amplitude is determined from the difference of these two values.

20. A method according to claim 18 or 19, claim the time constant of the asymmetric filters (5, 6) is made variable.

21. A method according to claim 13, characterised in that the mean noise amplitude is determined once when the controller is commissioned and is then adjusted to the determined value.

22. A method according to any one of claims 13 to 20, characterised in that the mean noise amplitude is determined periodically and recurrently and is then adjusted to the determined value.

23. A method according to any one of claims 13 to 20, characterised in that the mean noise amplitude is determined continuously.

24. A method according to any one of claims 13 to 20, characterised in that the mean noise amplitude is always determined when there is a change of a process parameter of the control system, e.g. flow-rate, pressure, control difference of the surge controller, rotational speed, turbine blade setting or output of a turbocompressor, or of the controller output of any controller involved, and is then adjusted to the determined value.

25. A method according to any one of claims 13 to 20, 22 or 24, characterised in that on the occurrence of a change in a process parameter of the control system during the determination of the mean noise amplitude the determination is immediately terminated and started afresh.

26. A method according to any one of claims 13 to 23, characterised in that an increased factor of safety is added to the mean noise amplitude determined.

27. A method according to any one of claims 1 to 26, characterised in that the controller is a surge limit controller for turbocompressors and that the time constant is additionally influenced by the output signal from the surge limit controller.

28. A method according to any one of claims 1 to 26, characterised in that the controller is a surge limit controller for turbocompressors and that the time constant is additionally influenced by the control difference of the surge limit controller.

29. A method according to any one of claims 1 to 28, characterised in that the alteration or adjustment of the time constants is not effected immediately the corresponding condition arises, but is temporally delayed.

30. A method according to claim 29, characterised in that the alteration of the time constants is not effected immediately the corresponding condition arises, but is only effected after one or more of the influence variables have exceeded a safety threshold.

31. A method according to claim 28, characterised in that the control difference is formed in such a way that the time constant is ineffective.

32. A method according to claim 29 or 30, characterised in that the temporal delay or the safety threshold is dependent on the amount of the deviation determined on the input side.

33. A method according to claim 32, characterised in that the temporal delay or the safety threshold is adjusted depending on the gradient of the difference between the filter input and output.

**Revendications**

1. Procédé pour traiter un signal d'entrée ($X_1$) affecté de bruits ou de fluctuations et destiné à un régulateur prévu dans un système de réglage, une courbe limite étant définie dans le champ de caractéristiques du système de réglage,
   caractérisé en ce que le signal d'entrée est, avant l'envoi au régulateur, filtré par un filtre (1) ayant une constante de temps réglable et en ce que le niveau du signal d'entrée est contrôlé, la constante de temps utilisée pour filtrer le signal d'entrée lors d'une variation du niveau de ce signal correspondant à un rapprochement par rapport à la courbe limite étant plus petite que lors d'une variation du niveau de ce signal correspondant à un éloignement par rapport à la courbe limite.

2. Procédé selon la revendication 1, caractérisé en ce que le signal d'entrée ($X_1$) destiné au régulateur est filtré avant l'envoi au régulateur, en ce que le signal filtré ($X_2$) est comparé au signal non filtré ($X_1$) et en ce qu'on règle la constante de temps du filtre (1) en fonction de la grandeur et du signe de la différence entre le signal filtré et le signal non filtré.

3. Procédé selon la revendication 2, caractérisé en ce que lors du dépassement unilatéral d'un seuil de commutation ($X_S$), la constante de temps ($T_F$) est réduite dans un étage de valeur limite (2) à une valeur fixée à l'avance, le cas échéant à zéro.

4. Procédé selon la revendication 3, caractérisé en ce que la constante de temps ($T_F$) est, après le franchissement vers le bas du seuil de commutation ($X_S$), ramenée à la constante de temps initiale, soit immédiatement, soit avec un décalage suivant un seuil d'hystérésis.

5. Procédé selon la revendication 2, caractérisé en ce que la constante de temps ($T_F$) est réglée en fonction de la grandeur de la différence entre le signal filtré et le signal non filtré, de manière que pour une différence plus grande, la constante de temps soit plus courte.

6. Procédé selon la revendication 5, caractérisé en ce que le réglage de la constante de temps ($T_F$) est fonction, de façon non linéaire, de la différence entre le signal filtré et le signal non filtré.

7. Procédé selon la revendication 2, caractérisé en ce que les constantes de temps différentes n'agissent qu'à l'état non stationnaire.

8. Procédé selon l'une des revendications 1 à 7, caractérisé en ce que, en fonction du signe de la variation du signal, la constante de temps est réglée suivant une fonction différente à partir de la différence entre le signal filtré et le signal non filtré.

9. Procédé selon l'une des revendications 1 à 7, caractérisé en ce que, en fonction du signe de la variation du niveau du signal, la constante de temps est réglée suivant la même fonction à partir de la différence entre le signal filtré et le signal non filtré, mais avec des paramètres différents.

10. Procédé selon les revendications 1 à 9, caractérisé en ce que la constante de temps variable n'agit que lors d'une variation du niveau du signal indiquant un rapprochement par rapport à la courbe limite, le filtre fonctionnant avec une constante de temps fixe lors des autres variations du niveau du signal.

11. Procédé selon la revendication 1, caractérisé en ce que la constante de temps variable n'agit que lors d'une variation du niveau du signal indiquant un éloignement par rapport à la courbe limite, aucun retard n'intervenant lors des autres variations du niveau du signal.

12. Procédé selon la revendication 11, caractérisé en ce qu'une constante de temps réglable et finie agit lors des deux types de variations du niveau du signal.

13. Procédé selon la revendication 11, caractérisé en ce que le signal d'entrée destiné au régulateur est filtré avant l'envoi au régulateur, le signal filtré représentant la valeur de pointe actuelle maximale ou minimale du signal d'entrée, en ce qu'on détermine l'amplitude moyenne du bruit dans le signal d'entrée et en ce qu'on ajoute cette amplitude moyenne du bruit au signal filtré ou on la retranche de ce signal.

14. Procédé selon la revendication 13, caractérisé en ce que le signal d'entrée est filtré, le signal filtré est comparé au signal non filtré, l'amplitude moyenne du bruit étant déterminée à partir de leur différence.

15. Procédé selon la revendication 14, caractérisé en ce que le filtre destiné à la détermination de la valeur instantanée et le filtre destiné à la détermination de l'amplitude moyenne du bruit ont des constantes de temps différentes.

16. procédé selon la revendication 13, caractérisé en ce que l'amplitude moyenne du bruit est déterminée par un circuit de calcul mémorisant les valeurs de pointe maximales et minimales du signal pendant une période de temps fixe prédéterminée, formant la différence entre la plus grande valeur maximale et la plus petite valeur minimale et la divisant par deux.

17. Procédé selon la revendication 16, caractérisé en ce que la longueur de la période de temps est de type variable.

18. Procédé selon la revendication 13, caractérisé en ce que l'amplitude moyenne du bruit est déterminée par deux filtres asymétriques (5, 6) qui ont une constante de temps active lors d'une variation du signal dans un sens et qui n'ont pas de constante de temps dans l'autre sens.

19. Procédé selon la revendication 17, caractérisé en ce que le filtre (5) retarde les signaux ascendants lors de leur passage et ne retarder pas les signaux descendants, de sorte que son signal de sortie est constamment voisin de la valeur de pointe minimale, tandis que le filtre (6) laisse passer les signaux ascendants sans les retarder et les signaux descendants en les retardant, de sorte que son signal de sortie est constamment voisin de la valeur de pointe maximale, et en ce que le double de l'amplitude moyenne du bruit est déterminé à partir de la différence de ces deux valeurs.

20. Procédé selon la revendication 18 ou la revendication 19, caractérisé en ce que la constante de temps des filtres asymétriques (5, 6) est de type variable.

21. Procédé selon la revendication 13, caractérisé en ce que l'amplitude moyenne du bruit est déterminée une fois pour toutes lors de la mise en fonctionnement du régulateur et est ensuite réglée à cette valeur déterminée.

22. Procédé selon l'une des revendications 13 à 20, caractérisé en ce que l'amplitude moyenne du bruit est déterminée à nouveau périodiquement et est ensuite réglée à la valeur déterminée.

23. Procédé selon l'une des revendications 13 à 20, caractérisé en ce que l'amplitude moyenne du bruit est déterminée de façon continue.

24. Procédé selon l'une des revendications 13 à 20, caractérisé en ce que l'amplitude moyenne du bruit est déterminée à chaque variation d'un paramètre de fonctionnement du système de réglage, par exemple du débit, de la pression, de la différence de réglage du régulateur de pompage, de la vitesse de rotation, de la position des aubes directrices ou de la puissance d'un turbocompresseur ou du signal de réglage de sortie d'un régulateur associé quelconque, cette amplitude étant ensuite réglée à la valeur déterminée.

25. Procédé selon l'une des revendications 13 à 20, 22 ou 24, caractérisé en ce que lors de l'arrivée d'une variation d'un paramètre de fonctionnement du système de réglage pendant la détermination de l'amplitude moyenne du bruit, cette détermination est immédiatement arrêtée et remise en route.

26. Procédé selon l'une des revendications 13 à 23, caractérisé en ce qu'une marge de sécurité est ajoutée à l'amplitude moyenne du bruit déterminé.

27. Procédé selon l'une des revendications 1 à 26, caractérisé en ce que le régulateur est un régulateur de limite de pompage pour turbocompresseurs et en ce que la constante de temps est, de plus, soumise à l'influence du régulateur de limite de pompage.

28. Procédé selon l'une des revendications 1 à 26, caractérisé en ce que le régulateur est un régulateur de limite de pompage pour turbocompresseurs et en ce que la constante du filtre est, de plus, soumise à l'influence de la différence de réglage du régulateur de limite de pompage.

29. Procédé selon l'une des revendications 1 à 28, caractérisé en ce que la variation et, le cas échéant, le réglage de la constante de temps n'ont pas lieu immédiatement lors de l'établissement de la condition correspondante, mais après un temps de retardement.

30. Procédé selon la revendication 29, caractérisé en ce que la variation de la constante de temps n'a pas lieu immédiatement lors de l'établissement de la condition correspondante, mais seulement après qu'une ou plusieurs grandeurs d'influence aient franchi un seuil de sécurité.

31. Procédé selon la revendication 28, caractérisé en ce que la différence de réglage est formée de manière que la constante de temps n'agisse pas.

32. Procédé selon la revendication 29 ou la revendication 30, caractérisé en ce que le temps de retardement et, le cas échéant, le seuil de sécurité sont fonction de la valeur de l'écart déterminé du côté de l'entrée.

33. Procédé selon la revendication 32, caractérisé en ce que le temps de retardement et, le cas échéant, le seuil de sécurité sont réglés en fonction du gradient de la différence entre le signal d'entrée et le signal de sortie du filtre.

FIG. 1

FIG. 2

FIG. 3

FIG. 4

FIG. 5

FIG. 6